# EUROPEAN PATENT APPLICATION

(11) **EP 1 377 133 A1**
(43) Date of publication of application: **02.01.2004**
(21) Application number: 02405502.2
(22) Date of filing: 18.06.2002
(51) Int. Cl.: H05B 33/12, H01J 17/49, H01J 61/92, H01J 61/067, H01J 63/06, H01J 65/04, H01J 9/00

(54) **Lighting element with luminescent surface and uses thereof**

(71) Applicant: Alcan Technology & Management Ltd., 8212 Neuhausen am Rheinfall (CH)
(72) Inventor: Furneaux, Robin C., Banbury, Oxfordshire, OX15 6NA (GB); Hotz, Walter, CH-8222 Beringen (CH); Kang, Karam, Kingston, Ontario K7M 2V4 (CA)

(57) **Abstract**

The invention concerns a lighting element (1) containing a dielectric layer (5) of a metal oxide with a front surface and a back surface, where the dielectric layer (5) contains an arrangement of elongated pores (8) extending between front and back surfaces through the dielectric layer (5) and the pores (8) are open to the front surface, and a base electrode (7) made from an electrically conductive material is arranged on the back surface, and in the pores (8) are arranged emitter rods (4) of an electrically conductive material, and a translucent layer of counter-electrode (2) of an electrically conductive material is arranged over the front surface of the dielectric layer (5), and a layer of luminescent material (3) is arranged between the dielectric layer (5) and the base electrode (7). The layer of counter-electrode (2) is a part of the layer system of the lighting element (1), where the dielectric layer (5) has the function of a spacer and separates the base electrode (7) from the counter-electrode (2). The invention also concerns the use of such a lighting element on walls and facades of buildings, as a background light source for liquid crystal displays or as self-illuminating displays or signs.

## Description

The present invention concerns a lighting element with a luminescent surface containing a layer system with a base electrode layer made from an electrically conductive material and directly or indirectly arranged thereon a translucent dielectric layer with a front surface and a back surface facing the base electrode, where the dielectric layer contains an arrangement of pores extending between the front and back surfaces and the pores are open to the front surface, and emitter rods of an electrically conductive material are arranged within pores, where the emitter rods are connected to the base electrode in an electrically conductive manner, and opposite the emitter rods is a translucent counter-electrode of an electrically conductive material, and between the emitter rods and the counter-electrode is arranged a luminescent material. The invention also concerns the manufacturing and the use of the lighting element in accordance with the invention.

Luminescent materials or substances, i.e. solid, liquid or gaseous materials which can be stimulated to emit light, have been known for some time for the manufacture of lighting elements. Luminescent materials, also known as luminophores or fluorescent substances, can be stimulated to emit light by for example electromagnetic waves, such as ultraviolet (UV) radiation or visible light, by electric fields, by electron beams or by ions, e.g. ionised gas atoms or molecules. Luminescence can also include phosphorescence or fluorescence.

Luminescence achieved through the targeted, i.e. addressed, stimulation of individual light points is used for example in screens, whereas the unaddressed stimulation of a luminescent substance is used in lighting appliances.

In computer and TV screens for example, a targeted stimulation of individual luminescent points occurs through electron beams. In discharge lamps, such as fluorescent tubes, a luminescent substance is stimulated to emit light by way of UV radiation. Generally, gases are here used which emit UV radiation through stimulation by electron beams. Moreover the luminescent substance of discharge lamps can also be stimulated directly by ionised gas atoms or molecules.

For certain applications it is advantageous to have flat lighting elements with a total thickness as thin as possible and which can also be manufactured easily and cheaply in large quantities.

For example, flat lighting elements are known which are based on the principle of cold cathode field emission. These are distinguished by a cold cathode, which under the effect of an external electric field emits electrons which in turn stimulate a luminophore to emit light. High emission currents depend on high field strength which in turn depends on a high field. That can be achieved along with a low potential difference by minimising the distance between the emitters and the Anode.

Therefore in order to keep the operating voltage applied to the cathodes as low as possible whilst at the same time reaching the necessary high electrical field strengths, the cathode surfaces are provided with fine cathode points. An anode is placed opposite the cathode and absorbs the electrons emitted by the cathode points. As above mentioned the distance between the anode and the cathode points is minimised to achieve a high field.

There are various procedures according to which cathode surfaces can be produced with a multiplicity of cathode points. EP 0 351 110 for example describes a procedure for the manufacture of cold cathode emitter surfaces where an aluminium oxide surface is provided with numerous elongated pores arranged substantially orthogonal to the main surface of the aluminium oxide layer, the pores are filled with a metal, at least a part of this aluminium oxide layer is removed leaving a surface with exposed cathode points that are no longer surrounded by the aluminium oxide layer.

WO 96/06443 describes a targeted cold cathode field emission arrangement for displays and screens. A porous membrane of aluminium oxide is applied to a layering system with an addressable cathode. The pores of the membrane are filled with a conductive metal which forms emitter cathodes, where the emitter cathodes are conductively connected to the target cathodes and their front points end at the level of the front surface of the dielectric membrane. The anode is integrated into the phosphorus screen, which is arranged at a distance from the cathode.

Previously known flat lighting elements which work on the principle of luminescence generally have a relatively large total thickness. In addition, they are often expensive and complex to manufacture. In addition, in known flat lighting elements, the dimensional stability of the distance between the anode and the cathode is often too small, which leads to a lower and uneven light emission.

The purpose of this invention is therefore to propose a lighting element with a light-emitting surface based on the principle of luminescence, which has a small total thickness and is easy and cheap to manufacture.

In accordance with this invention, this is resolved in that the counter-electrode is part of the layer system and is a layer covering the pore cavities and arranged directly or indirectly on the front surface of the dielectric layer, and the luminescent material is arranged between the emitter rods and the layer of counter-electrode, and the dielectric layer is a spacer, which separates the base electrode and the counter-electrode.

The term "light" in this document means the electromagnetic radiation of the visible (to the human eye) spectrum and radiation from the infrared and ultraviolet ranges adjacent to the visible spectrum. Moreover the term "light" according this specification shall also encompass electromagnetic radiation of the soft X-ray spectrum.

Emitter rods are the electron-emitting, thread-like, wire-like or cone-like deposits in the pores. The emitter rods suitably lie completely in the pore cavity.

In a embodiment (A) according the invention, the luminescent material is arranged directly or indirectly as a layer covering the pore openings on the front surface of the dielectric layer. The counter-electrode is arranged directly or indirectly on the exposed surface of the luminescent layer. According this embodiment the emitter rods may end at the pore openings.

In a embodiment (B) according the invention, luminescent material is arranged in the pore cavity between the emitter rods and the pore openings. The luminescent particles can be deposited in the free pore cavity and fill this partly or fully.

In addition, the luminophore can be arranged partly or fully as a layer on the exposed surface of the pore inner walls, forming or retaining a preferably central pore cavity. The counter-electrode here is arranged directly or indirectly on the front surface of the dielectric layer. The luminophore can be arranged exclusively on the exposed surface of the pore inner walls between the pore openings and the emitter rods. In this case the luminophore is preferably deposited after depositing the emitter rods. Further the luminophore may also be deposited before the emitter rods and therefore also covering pore inner wall sections in the region where the emitter rods are subsequently deposited.

Optionally embodiment (A) and (B) may also be combined.

The luminescent particles arranged for example as a layer on the front surface of the dielectric layer have e.g. a size of up to 20 µm, preferably up to 10 µm. If the luminescent particles are deposited in the pores, it is preferable to use luminescent particles in the form of nanoparticles measuring e.g. 100 nm or smaller. In this embodiment the luminescent particles can be deposited on the pore walls or in the pores for example by way of an electrophoresis procedure.

The luminescent particles can also be deposited on the pore walls in the form of self-assembled monolayers (SAM), whereby the luminescent particles are attached as a functional group on the SAM's. Self-assembled monolayers are tightly packed monolayers formed through adsorption. SAM's can be constructed e.g. on the basis of phosphoric acid ester. "Self-assembled monolayers" are of a thickness of e.g. 1 to 10 nm, preferably 1 to 5 nm. Further details of the properties and structure of SAM's can be found in the "Ullmann's Encyclopaedia of Industrial Chemistry, 6. Edition, 2001 Electronic Release, Ch. 1.5.1".

The luminescent layer can also consist of "multilayers", which are formed under controlled conditions by the sequential adsorption of "self-assembled monolayers".

Correspondingly suitable compounds can be used as luminophores as detailed in e.g. Roempp, Chemical Lexicon, 10th Edition, 1997, p. 2389-2391. A suitable compound is e.g. ZnS. For the manufacture of ZnS layers, the pore cavities can be coated e.g. with a solution of ZnSO₄. Once the solution is dry and the pores have been gassed with H₂S, a layer of ZnS is formed in the pores.

In a further development of the invention a layer-like intermediate electrode can be arranged directly or indirectly on the front surface of the dielectric layer, surrounding the pore openings, i.e. not covering these. The intermediate electrode therefore has a perforated structure. The intermediate electrode may be applied in embodiment (A) and embodiment (B) as well.

In the lighting element according to embodiment (A) but with an additional intermediate electrode, the luminescent layer is arranged directly or indirectly on the layer of intermediate electrode and the layer of counter-electrode directly or indirectly on the luminescent layer, whereby an isolation layer can be arranged between the luminescent layer and the counter-electrode and/or the intermediate electrode.

In the lighting element according to embodiment (B) but with an additional intermediate electrode, at least one extra dielectric layer is arranged over the intermediate electrode and the layer of counter-electrode is arranged on the at least one extra dielectric layer.

The intermediate electrode is preferably a layer of electrically conductive and reflective material such as metal (e.g. aluminium, silver or titanium) applied e.g. by PVD (physical vapour deposition). The layer thickness of the intermediate electrode can be e.g. 20 - 150 nm.

The base electrode can be made from an anodisable metal, i.e. a valve metal such as magnesium, titanium or aluminium and an alloy thereof. The base electrode is preferably made from aluminium or an aluminium alloy and in particular from pure aluminium. The base electrode can be made e.g. from aluminium with a purity of 95% or higher, preferably 98.3% or higher, in particular 99.5% or higher. The base electrode is preferably a layer formed by a coating procedure to a substrate. The surface of the base electrode may also be formed by the substrate itself. The substrate may be made of a flat element, such as a plate, sheet or film or of a shaped body. The substrate may be produced by means of e.g. a rolling, extrusion, forging or flow press procedure. The substrate for the base electrode may also be made of an extruded profile or a cast product.

The dielectric layer is e.g. a layer or membrane from a translucent metal oxide, preferably aluminium oxide. The dielectric layer is preferably a layer manufactured by the anodic oxidation of a metal substrate under pore-forming conditions.

The dielectric layer preferably comprises a porous layer, or a porous layer and where applicable a barrier layer forming the back surface. If a barrier layer is provided, this suitably has a thickness which allows a flow of electrons between the base electrode and the emitter rods. Therefore the layer thickness is preferably less than 50 nm, particularly less than 30 nm. The barrier layer itself can also contain inclusions which increase its conductivity.

Where the pores of the dielectric layer contains in addition to emitters luminescent material (embodiment (B)) or a plasma-forming gas (principle (ii), (iii)) then the dielectric layer for example has a thickness of greater than 1 µm and preferably greater than 2 µm or in particular greater than 5 µm and less than 150 µm, preferably less than 100 µm and in particular less than 70 µm.

Where the pores of the dielectric layer contains only emitters and the luminescent material covers the pore openings (embodiment (A)), then the dielectric layer has preferably a lower thickness as above described. The thickness of the dielectric layer may be here 20 µm or less, preferably, 10 µm or less and particularly 0,05 to 5 µm. However the thickness of the dielectric layer is preferably determined by the length of the emitter rods and the preference for them to extend over nearly all the pore length.

According the current state of technology nano-phosphors as luminescent material can be produced in a size of 50-100 nm. If these particles are to be introduced into the pores, then the pore diameter at the front surface of the dielectric layer are preferably greater than 50 nm, preferably greater than 100 nm. It may be possible to relax these criteria where alternative light-emitting substances or plasma-forming gases are introduced into the pores.

If the metallic intermediate electrode is to be deposited, e.g. vacuum deposited, on the dielectric layer surface, then the amount of deposit is preferably sufficient to provide an adequately conductive surface film but not so much to seal the pores and block the path of emitted electrons. Therefore if an intermediate electrode is applied, e.g. by means of vacuum deposition, then the pore diameter at the front surface of the dielectric layer beneath the intermediate electrode is preferably 10 nm or greater, particularly 50 nm or greater and preferably 200 nm or less, particularly 90 nm or less.

The pore diameter at the front surface of the dielectric layer is preferably 10 to 250 nm or even greater.

The pores are suitably aligned substantially orthogonal to the front surface of the dielectric layer. The dielectric layer has for example a pore density of 10⁸ pores per cm² or higher. The separation between the emitters is preferably 0,05 - 10 µm. The dielectric layer preferably has a thickness greater than the mean diameter of the pores. The pore population density and pore diameters may be made to vary through the dielectric layer thickness.

The dielectric layer also serves as a spacer, which separates the base electrode and the counter-electrode. The distance between the base electrode and the counter-electrode is therefore relatively small, allowing the operation of the lighting element with relatively low electric voltages. In order to reduce power requirements, field emission should be at a field strength less than 100 V/µm, preferably less than 30 V/µm and particularly less than 20 V/µm. This defines the separation between the emitter rods and the counter-electrode or, if present, the intermediate electrode.

The pores contain thread-like or wire-like emitter rods which are connected electrically conductively to the base electrode. If the dielectric layer does not contain a barrier layer, the electrical contact between the base electrode and the emitter rods is made directly.

The emitter rods are made from an electrically conductive material such as cobalt, nickel or another suitable metal and are preferably deposited in the pores by means of electroplating. The emitter rods are preferably minimised in size and particularly in length. Thus, the length of the emitter rods is, on average, preferably less than 10 µm, particularly less than 5 µm and most preferably less than 1 µm. If the emitter rods are too large, they will tend to scatter and absorb the light produced. Another reason why the emitter rods should be minimised in length is to control the uniformity oh their length, which will also contribute to the uniformity of light emission.

The emitter rods may contain emitter points at their exposed ends made from refractory metal which can also withstand oxidation. The refractory metal can be gold, molybdenum, tungsten, palladium, platinum or another metal which is difficult to oxidise.

The emitter rods suitably lie in the pore cavities and under the front surface of the dielectric layer. The emitter rods (where applicable with emitter points) preferably extend over a distance of less than the pore length. In embodiments of the invention where the dielectric layer only contains emitters and the light-emitting substance is beyond its front surface (embodiment (A)), then the emitter rods preferably extend very close to the front surface, but preferably no closer than two pore diameters.

The counter-electrode is suitably present as a translucent, electrically conductive layer made of a translucent conductive coating. The layer is preferably made from or contains doped tin oxide such as indium tin oxide (ITO) or non-stoichiometric zinc oxide. Indium tin oxide is both electrically conductive and translucent. In addition, on the free surface of the translucent, electrically conductive layer, conductor paths can be provided to improve supply and/or dissipation of electrical currents. The conductor paths suitably have a better conductivity than the translucent layer underneath. They can be made from a metal conductor with a thickness of e.g. less than 0.1 mm. The conductor paths can be arranged in the form of a grid and e.g. have a mesh width of 5 - 10 mm.

The counter-electrode is suitably deposited in a vacuum coating procedure or by pyrolysis of tin oxide.

In addition, one or more translucent protective layers can be arranged on the counter-electrode, which are deposited e.g. by means of a vacuum coating procedure. In particular, these can be ceramic layers, for example from or with compounds of the formula SiOₓ where x is a number from 1 to 2, or AlyO_{z}, whereby y/z is a number from 0.2 to 1.5, or simple fluorides. The protective layer may also be made of an external sol-gel coating.

The layer thickness' can, for example in case of vacuum deposition, be 5 to 500 nm, in particular 5 to 200 nm. The layer thickness may also be higher in the range of up to 1 to 2 µm. The layer thickness also serves to seal the pores in order to prevent the exchange of gases or to maintain a permanent vacuum.

Where applicable the counter-electrodes can also fulfil the function of a sealing layer with the properties described in the paragraph above.

The lighting element according the invention can operate according three different principles (i), (ii), (iii). The lighting element operating according the principle (i) is as a cold cathode field emission device. The base electrode is hereby the base cathode, the emitter rods are emitter cathodes and the counter-electrode is the anode. The pore cavity is partly or fully evacuated. The luminescent material is stimulated by means of electron beams which are emitted by the emitter rods on application of direct voltage. The intermediate electrode provided where applicable is a gate electrode, with which a pre-acceleration voltage can be established which will serve to accelerate the electrons. The gate electrode preferably has a lower positive potential than the anode. The principle (i) is preferably applied to the embodiment (A) of the invention.

The lighting element operating according the principle (ii) is stimulated by means of UV radiation. The pore cavity contains a plasma-forming gas, preferably an inert gas, in particular argon, neon, krypton, helium or a mixture thereof. The gases ionise in the pore cavity by the application of an alternating voltage between electrode and counter-electrode, whereby gas discharge procedures lead to the emission of UV radiation through the plasma. The UV radiation stimulates the luminescent material to emit light. The luminescent material according the principle (ii) may also be directly stimulated by the ionised gas atoms or molecules.

The intermediate electrode, provided where applicable, serves to "ignite" the plasma, i.e. the intermediate electrode has the function of a starter electrode to initialise the plasma, while the counter-electrode provides an alternating current for continuous operation. The intermediate electrode preferably has a lower potential than the counter-electrode.

The lighting element operating according the principle (iii) is based on electro-luminescence, i.e. the luminescent substance is stimulated by the application of an electric field. The luminescent substances include light emitting polymers, non-metallic or organo-metallic compounds. Some are referred to as organic light emitting diodes (OLED).

The principles (ii), (iii) are preferably applied to the embodiment (B) of the invention.

In a special embodiment of the invention, the lighting element can have a matrix addressing of the base electrode and/or counter-electrode for the purpose of directing the light emission of individual surface points or surface sections. The single pores with the emitter rods are so-called emission centers which can be controlled.

The base electrode and counter-electrode here can be arranged e.g. in the form of grid-like conductor paths. Addressable systems are of particular interest for display applications.

The anode-layer can be selectively applied, so that only specific emission centers are activated. The selective application of the anode-layer can be realised by means of a printing process, e.g. lithography, or by means of laser aberration of the anode layer. This allows the "writing in" of emission sites at pre-determined locations. The selective apply of the anode-layer allows to select a macro region of a number of active emission centers to form a pattern which could be addressed by matrix type addressing of the anodes. Further, the selective apply of the anode-layer allows to decouple emission centers from the whole structure, if they are faulty, e.g. if they were shorted during use or production.

For the use of the lighting element in accordance with the present invention for lighting purposes, a complex addressing system of the electrodes on a microscopic level can be omitted as the luminescent material in the lighting element is stimulated simultaneously over a large area by application of an electrical voltage, i.e. over surface sections which are perceptible to the human eye.

A luminous element without addressing the luminescent particle can be manufactured (as an example) by the steps of
a) providing a base electrode made of aluminium
b) providing a porous dielectric anodic aluminium oxide layer by anodising the base electrode,
c) providing wire-like emitter rods in the pores of the dielectric layer having back ends and front ends, where the front ends of the emitter rods lie below the front surface of the dielectric layer
characterised by the steps of
i) providing the pores and/or the front surface of the dielectric layer with a layer of luminescent material before or after the deposit of the emitter rods,
ii) providing the front surface of the dielectric layer directly or indirectly with a layer of a counter-electrode.

The dielectric layer is preferably manufactured by means of anodisation directly from the aluminium surface of the base electrode, whereby anodisation under appropriate electro-chemical conditions, e.g. redissolving condition, leads to a porous oxide layer.

The diameter and spacing of the pores depends on the anodising voltage. When e.g. X volts are applied, the pore diameter is typically about X nm and the pore spacing about 2.5^{*}X. Between the bottom of the pores and the metal/oxide interface there is a barrier layer of thickness about X nm. The total thickness of the porous anodic oxide layer increases coulombically. Thus, anodising conditions, including time, voltage and electrolyte composition and temperature, can be chosen in known manner to create an anodic oxide film of chosen thickness containing a uniform array of pores of chosen diameter and spacing.

The layer of base electrode is anodised in an appropriate electrolyte under direct or alternating current conditions of preferably a voltage less than 200 V, whereby a porous aluminium oxide layer is created. Phosphoric acid or oxalic acid are preferably used as electrolytes. The anodisation in phosphoric acid or oxalic acid allows the production of pores with large diameters, which facilitates the deposition of a luminescent material in the pore cavities.

In addition to a porous layer, the anodisation also creates a barrier layer on the base electrode. As the barrier layer is too thick for electro-deposition of a metal into the pores from a neutral pH solution the barrier layer has to be thinned or removed and made suitable for electro-depositing. These can happen by allowing the anodic film to recover at a lower voltage at about 30 V or less. Recovery can be performed in phosphoric acid or sulphuric acid. EP 178 831 describes for example the technique of voltage reduction which results in a thinning and eventual removing of the barrier layer.

In a further step, the emitter rods are deposited in the pores e.g. by means of electrolyte precipitation. Refractory metal rods may be produced by galvanic displacement of non-refractory metallic deposits in the pores.

The surface of the aluminium oxide layer may be subsequently polished to eliminate all metal deposits from the surface.

In a further subsequent step, the thread-like emitter rods deposited in the pores are electrochemically redissolved so that the points of the deposits come to rest in the pore cavities and below or behind the surface of the aluminium oxide layer.

If necessary, emitter points as described above can also be deposited on the exposed surface of the emitter rods, where applicable e.g. by means of electron beam vaporisation in a vacuum chamber, electrochemical deposition or galvanic displacement of non-refractory metallic material. In a subsequent electro-chemical procedure, surplus metal deposits precipitated by the electron beam vaporisation on the aluminium oxide layer can be removed.

To produce a lighting element in accordance with embodiment (B), luminescent material is deposited in the open pore cavities. The luminescent material is preferably deposited on the free pore internal walls.

To produce a lighting element in accordance with the embodiment (A), the luminescent material is deposited as a layer directly or indirectly on the front surface of the dielectric layer.

In a further subsequent step, a layer of ITO or non-stoichiometric zinc oxide is deposited directly or indirectly on the dielectric layer, e.g. by means of a vacuum coating procedure.

To improve the current flow, conductor paths can be deposited over the ITO or zinc oxide layer.

In addition, one or more translucent protective layers, in particular ceramic protective layers, can be deposited on the counter-electrode e.g. by means of gas or vapour phase deposition in the vacuum or through PVD. The counter-electrode and one or more protective layers can be deposited e.g. in a continuous vacuum thin layer process, and in particular in direct succession.

In a special embodiment of the invention, an intermediate electrode can be directly deposited on the dielectric layer.

The individually listed procedures above are preferably continuous process steps, where in this case the base electrode is an aluminium strip present as a coil.

The operation of a lighting element in accordance with the invention is characterised in that the light emitted by the luminescent material in the direction of the counter-electrode emerges directly to the outside through the ITO layer while the light emitted in the direction of the base electrode is reflected by the metal surface of the base electrode and/or the intermediate electrode. As the dielectric layer is translucent, the majority of the light emitted is guided directly or indirectly towards the exterior as desired.

The present invention has the advantage that thanks to the dielectric layer as a spacer, the lighting element has a precise and predeterminable distance, extremely constant over the surface, between the base electrode and the counter-electrode. An electric field applied uniformly and an uniform distance between the base electrode and the counter-electrode finally lead to a uniform light emission.

The lighting element in accordance with the invention is distinguished by low production costs as all procedures can be performed on a large industrial scale. Procedures such as anodising, galvanising (electro-plating, electro-depositing) and electrophoresis are already in commercial use. In addition, the vacuum coating procedure as a continuous coating procedure has now become established for large industrial applications.

Lighting elements in accordance with the invention, especially those without specific addressing of individual luminescent points, can be used e.g. for lighting purposes. Lighting elements in accordance with the invention are preferably flat or have a large surface area and can be used for walls and facades of buildings, in the interior of transport means over water, land or air, such as road and rail vehicles, aircraft and ships. The lighting elements in accordance with the invention can be used in large areas. In addition, lighting elements in accordance with the invention can be used as background lighting for liquid crystal displays (LCDs), as self-illuminating display or advertising panels, or as self-illuminating displays or signs.

Lighting elements according the invention may also be in the form of shaped elements. They may have emission in multiple directions. This by anodising from different faces of an aluminium component.

Lighting elements in accordance with the invention with specific addressing of the individual luminescent points can be used, e.g. as computer or TV screens, or as any form of flat display screen.

A more detailed explanation of the invention is given below as an example and with reference to the enclosed diagrams. These show:
- Fig. 1:: a diagrammatic cross-section through a lighting element in accordance with a first embodiment;
- Fig. 2:: a diagrammatic cross-section through a lighting element in accordance with a second embodiment;
- Fig. 3:: a diagrammatic cross-section through a lighting element in accordance with a third embodiment;
- Fig. 4:: a diagrammatic cross-section through a lighting element in accordance with a fourth embodiment.

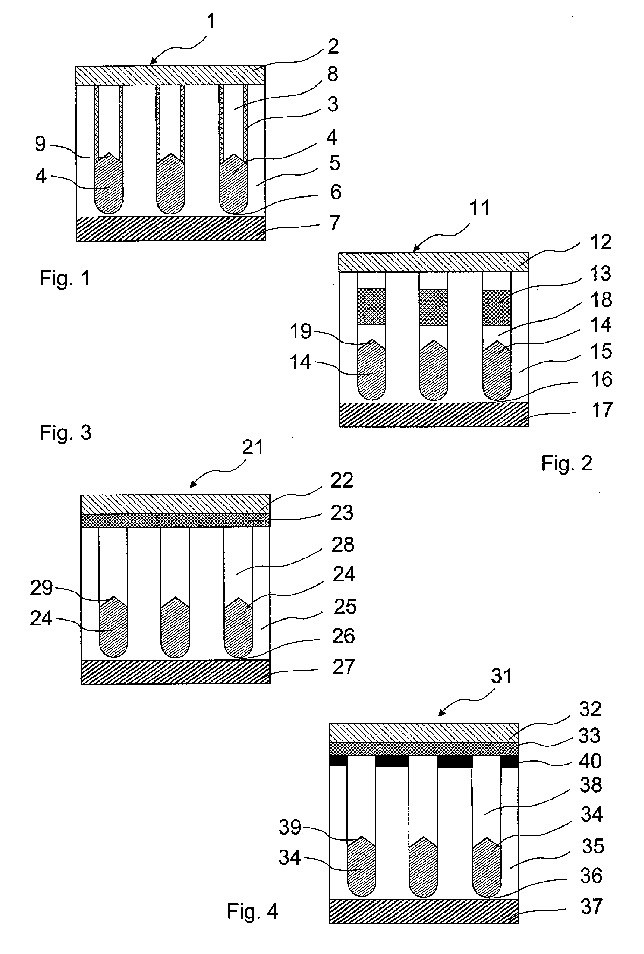

The lighting element 1, 11, 21, 31 as in Fig. 1, 2, 3 and 4 contains a base electrode 7, 17, 27, 37 of highly reflective aluminium, and arranged on this a porous dielectric layer 5, 15, 25, 35 of aluminium oxide. The dielectric layer can if required contain a barrier layer 6, 16, 26, 36 of a thickness of less than 30 nm, although this is not absolutely necessary. In the pores 8, 18, 28, 38 there are e.g. galvanically deposited emitter rods 4, 14, 24 made from metal with emitter points 9, 19, 29, 39, which are conductively connected to the base electrode 7, 17, 27, 37. Over the front surface of the dielectric layer 5, 15, 25, 35 there is a layer of counter-electrode 2, 12, 22, 32 of indium tin oxide (ITO) deposited e.g. by a vacuum coating process.

A first version of embodiment (B) is shown in Fig. 1. It is characterised in that a luminescent layer 3 is arranged on the free pore inner walls, forming or retaining a central pore cavity. The counter-electrode 2 is applied directly to the front surface of the dielectric layer 5.

A second version of embodiment (B) is shown in Fig. 2. It is characterised in that part of the volume of the free pore recess is filled with a luminescent material 13. If required, the whole free pore recess 18 can be filled with the luminescent material 13. The counter-electrode 2 is applied directly to the front surface of the dielectric layer 5.

Fig. 3 shows a first version of the embodiment (A). It is characterised in that a luminescent layer 23 covering the pores 28 is applied directly to the front surface of the dielectric layer 25. The counter-electrode 22 is applied directly to the luminescent layer 23.

The embodiment in Fig. 4 shows a second version of embodiment (A). It is characterised in that a perforated layer of intermediate electrode 40 not covering the pore cavities is directly applied to the front surface of the dielectric layer 35 and a luminescent layer 33 covering the pores 38 is applied directly to the intermediate electrode 40. The counter-electrode 32 is directly applied to the luminescent layer 33.

The lighting element in Figs. 1-4 can be used for an operation in accordance with the principle (i) of cold-cathode-field emission under direct current conditions, where electron emissions are generated by application of a voltage. The pore cavities in this case are either partly or fully evacuated. The lighting element as in Figs. 1-4 can also be used in an operation in accordance with the principle (ii) of gas discharge under alternating current conditions. The pores in this case are filled with a plasma-forming gas.

## Claims

1. Lighting element (1, 11, 21, 31) with a luminescent surface containing a layer system with a base electrode layer (7, 17, 27, 37) made from an electrically conductive material and directly or indirectly arranged thereon a translucent dielectric layer (5, 15, 25, 35) with a front surface and a back surface facing the base electrode, where the dielectric layer (5, 15, 25, 35) contains an arrangement of pores (8 18, 28, 38) extending between the front and back surfaces and the pores (8 18, 28, 38) are open to the front surface, and emitter rods (4, 14, 24, 34) of an electrically conductive material are arranged within pores, where the emitter rods are connected to the base electrode in an electrically conductive manner, and opposite the emitter rods is a translucent counter-electrode of an electrically conductive material, and between the emitter rods and the counter-electrode is arranged a luminescent material,
**characterised in that**
the counter-electrode (2, 12, 22, 32) is part of the layer system and is a layer covering the pore cavities (8 18, 28, 38) and arranged directly or indirectly on the front surface of the dielectric layer, and luminescent material (3, 13, 23, 33) is arranged between the emitter rods (4, 14, 24, 34) and the layer of counter-electrode (2, 12, 22, 32), and the dielectric layer (5) is a spacer which separates the base electrode (7, 17, 27, 37) and the counter-electrode.

2. Lighting element according to claim 1, wherein the emitter rods (4, 14, 24, 34) extend over a distance of less than the pore length and preferably extend no closer than two pore diameters to the front surface of the pores.

3. Lighting element according to any of claims 1 to 2, wherein the luminescent material is arranged as a layer (23) covering the pore cavities (28), directly or indirectly on the front surface of the dielectric layer (25), and the counter-electrode (22) is arranged directly or indirectly on the exposed surface of the luminescent layer (23).

4. Lighting element according to any of claims 1 to 3, wherein the luminescent material (3, 13) is arranged in the pore cavity (8, 18) between the emitter rods (4, 14) and the pore openings.

5. Lighting element according to any of claims 1 to 4, wherein the luminescent material is arranged partly or fully as a layer (3) on the exposed surface of the pore inner walls to form a central pore cavity.

6. Lighting element according to any of claims 1 to 5, wherein a layer of intermediate electrode (40) of a conductive material, preferably metal, surrounding the pore openings is arranged directly or indirectly on the dielectric layer (35), and the counter-electrode (32) is arranged over the intermediate electrode (40), where between the counter-electrode (32) and the intermediate electrode (40) is arranged at least one luminescent layer (33) covering the pore openings and/or a further dielectric layer.

7. Lighting element according to any of claims 1 to 6, wherein the dielectric layer (5, 15, 25, 35) is an anodised layer of a metal oxide, in particular an aluminium oxide.

8. Lighting element according to any of claims 1 to 7, wherein the base electrode (7, 17, 27, 37) is made from aluminium or an aluminium alloy and the dielectric layer (5, 15, 25, 35) is an aluminium oxide alloy, preferably an aluminium oxide alloy produced by means of anodisation directly from the base electrode.

9. Lighting element according to any of claims 1 to 8, wherein the counter-electrode (2, 12, 22, 32) contains or consists of a layer of a transparent and conducting electrode, preferably of indium tin oxide (ITO).

10. Lighting element according to any of claims 1 to 9, wherein the lighting element is a cold cathode field emission device and the base electrode (7, 17, 27, 37) is a base cathode, the emitter rods (4, 14, 24, 34) are emitter cathodes and the counter-electrode (2, 12, 22, 32) is the anode and the luminescent material (3, 13, 23, 33) is stimulated by the electron beams emitted from the emitter rods and the pore cavity (8, 18, 28, 38) is partly or fully evacuated.

11. Lighting element according to any of claims 1 to 9, wherein the pore cavity (8, 18, 28, 38) contains a plasma-forming gas, preferably an inert gas, in particular argon, neon, and/or helium, and the luminescent material (3, 13, 23, 33) is stimulated under gas discharge processes under alternating current conditions.

12. Lighting element according to any of claims 1 to 9, wherein lighting element operates on basis of electro-luminescence whereby the luminescent substance (3, 13, 23, 33) is stimulated by the application of an electric field.

13. Lighting element according to any of claims 1 to 12, wherein one or more translucent protective layers are arranged on the counter-electrode (2, 12, 22, 32) where the protective layers serve to seal the pores in order to prevent the exchange of gases or to maintain a permanent vacuum.

14. Lighting element according to any of claims 1 to 13, wherein the lighting element has a matrix addressing of the base electrode and/or counter-electrode for the purpose of directing the light emission of individual surface points or surface sections, this to build a display.

15. A method of making a luminous element according to claim 1 by the steps of
a) providing a base electrode (7, 17, 27, 37) made of aluminium,
b) providing a porous dielectric anodic aluminium oxide layer (5, 15, 25, 35) by anodising the base electrode,
c) providing wire-like emitter rods (4, 14, 24, 34) in the pores of the dielectric layer having back ends and front ends, where the front ends of the emitter rods lie below the front surface of the dielectric layer,
**characterised by** the steps of
i) providing the pores (8, 18, 28, 38) and/or the front surface of the dielectric layer with a layer of luminescent material before or after the deposit of the emitter rods,
ii) providing the front surface of the dielectric layer directly or indirectly with a layer of a counter-electrode (2, 12, 22, 32).

16. Method according to claim 15, wherein the exposed surface of the pore walls is partly or fully coated with a luminescent material (3).

17. Method according to any of claims 15 to 16, wherein the counter-electrode contains or consists of a layer of indium tin oxide (ITO) and the counter-electrode (2, 12, 22, 32) is applied to the dielectric layer in a vacuum coating procedure.

18. Use of a lighting element (1, 11, 21, 31) according to claim 1 as a flat lighting element on walls and facades of buildings, as a background light source for liquid crystal displays (LCD) or as self-illuminating displays or signs.
